# FASCICULE DE BREVET EUROPEEN

(11) **EP 0 489 659 B1**
(45) Date de publication et mention de la délivrance du brevet: **03.01.1996**
(21) Numéro de dépôt: 91403288.3
(22) Date de dépôt: 05.12.1991
(51) Int. Cl.: C23C 14/32, C23C 14/54

(54) **Procédé de traitement de métaux par dépôt de matière, et four pour la mise en oeuvre dudit procédé**
Verfahren zur Behandlung von Metallen mittels Beschichtung sowie Anlage zur Durchführung des Verfahrens
Process for treatment of metals by deposition of material and furnace for carrying out the process

(30) Priorité: 06.12.1990 FR 9015331
(43) Date de publication de la demande: 10.06.1992
(73) Titulaire: INNOVATIQUE S.A., F-69680 Chassieu (FR)
(72) Inventeur: Damond, Eric, F-69300 Caluire (FR); Dervieux, Georges, F-69800 St. Priest (FR); Jacquot, Patrick, F-69680 Chassieu (FR)
(74) Mandataire: de Saint-Palais, Arnaud Marie

(56) Documents cités:
- EP-A- 0 280 315
- FR-A- 2 465 793
- GB-A- 2 227 755
- US-A- 3 306 764
- US-A- 4 556 471

## Description

La présente invention concerne un procédé de traitement thermochimique de métaux par dépôt de matière sur un substrat à traiter.

Elle concerne plus particulièrement un procédé de dépôt sous vide de type PVD (Physical Vapor Deposition), selon lequel on évapore la substance d'une cible qui constitue une première électrode d'un four de traitement par bombardement ionique, et on dépose les particules ainsi produites sur un substrat constituant une deuxième électrode dont le potentiel est différent de celui de la première électrode.

Bien entendu, au cours de ce processus, le substrat est porté à la température de traitement, soit par l'effet calorifique engendré par le bombardement ionique, ou grâce à des moyens de chauffage prévus à l'intérieur du four, ou même par ces deux moyens conjugués.

Jusqu'ici, cette température de traitement était maintenue au-dessous d'un seuil déterminé, de l'ordre de 500°C, de manière à ne pas dépasser la température de revenu de l'acier trempé et ainsi, à éviter la détérioration des caractéristiques mécaniques des pièces traitées (dureté, résistance à la traction...) que l'on constate dans la pratique lorsqu'on dépasse cette température. En outre, il convenait d'éliminer les risques de déformation des pièces traitées et de rester dans la gamme de température autorisée par la cible ainsi que par les moyens utilisés pour contrôler son évaporation.

Cette limitation en température était impérative dans le cas de l'utilisation d'un magnétron servant à engendrer à la surface de la cible, un champ magnétique permettant d'augmenter la vaporisation de la cible, sans provoquer la fusion de la cible.

Il est clair que dans ce cas, la température de traitement engendrée à l'intérieur du four doit être aussi éloignée que possible de la température de fusion de la cible et que cette température ne puisse pas provoquer une détérioration du circuit électromagnétique du magnétron.

En outre, une élévation de température au-delà du susdit seuil allait à l'encontre d'un avantage résultant de l'usage d'un magnétron qui permet de réduire la surchauffe du substrat par le bombardement d'électrons énergétiques provenant de la cible.

L'invention a plus particulièrement pour objet d'améliorer la qualité du traitement thermochimique précédemment décrit, notamment en ce qui concerne la régularité du dépôt (épaisseur, rugosité), de son ancrage dans le substrat (adhérence) ainsi que le temps de traitement. Elle a également pour but de maîtriser les traitements de dépôts d'halogénures métalliques qui, jusqu'ici, étaient difficiles à mettre en oeuvre ou faisaient intervenir des éléments très toxiques. Elle vise en outre à étendre la gamme des traitements de dépôts, notamment en permettant la réalisation de multicouches interdiffusées ou d'alliages binaires ou ternaires ainsi que des dépôts suivis d'une trempe.

Pour parvenir à ces résultats, l'invention propose d'aller à l'encontre des préjugés précédemment évoqués et d'effectuer les dépôts de matière avec une température de traitement située dans une gamme comprise entre 800 et 1300°C.

Pour parvenir à ce résultat, elle utilise un procédé de traitement selon lequel, conformément aux enseignements du brevet US 4 556 471, on évapore la substance d'une cible au moins en partie métallique qui constitue une première électrode d'un four de traitement par un bombardement ionique éventuellement assisté par une décharge d'arc électrique, et à déposer les particules ainsi évaporées sur un substrat porté à un potentiel d'une deuxième électrode qui est différent de celui de la première électrode, de manière à engendrer une décharge luminescente sur ledit substrat, celui-ci étant porté, au cours de ce dépôt, à une température de traitement.

Selon l'invention, ce procédé est caractérisé en ce que ladite température de traitement est supérieure à 600°C, et est, de préférence, comprise entre 800°C et 1300°C, et en ce que ladite cible ainsi que ses organes annexes situés dans le four soient constamment refroidis par un courant de fluide de refroidissement de manière à ce que, lorsque l'on atteint la température de traitement, la matière de la cible demeure solide et que l'évaporation produite à la surface de la cible s'effectue par sublimation.

Bien entendu, l'invention concerne également un four de traitement servant à la mise en oeuvre du procédé précédemment défini, ce four pouvant comprendre un ou plusieurs générateurs de vapeur à cible refroidie, installé dans un four à vide assisté ou non par plasma.

Grâce au fait que la cible demeure toujours à l'état solide, elle peut être placée verticalement ou horizontalement, à l'endroit le plus approprié. En pratique, la localisation du ou des générateurs de vapeur doit être réalisée de telle façon que les flux de vapeur métallique produits par les différents évaporateurs soient multidirectionnels et permettent une répartition du dépôt la plus homogène possible.

Des modes d'exécution de l'invention seront décrits ci-après, à titre d'exemples non limitatifs, avec référence aux dessins annexés, dans lesquels :
Les figures 1 et 2 sont des vues schématiques en coupe horizontale (figure 1) et en coupe verticale (figure 2) d'un four de traitement thermique équipé de quatre générateurs de vapeur ;
La figure 3 est une coupe axiale à plus grande échelle d'un générateur de vapeur utilisable pour la mise en oeuvre du procédé selon l'invention ;
Les figures 4 à 10 sont des diagrammes de température en fonction du temps qui illustrent divers types de traitement effectués conformément au procédé selon l'invention.

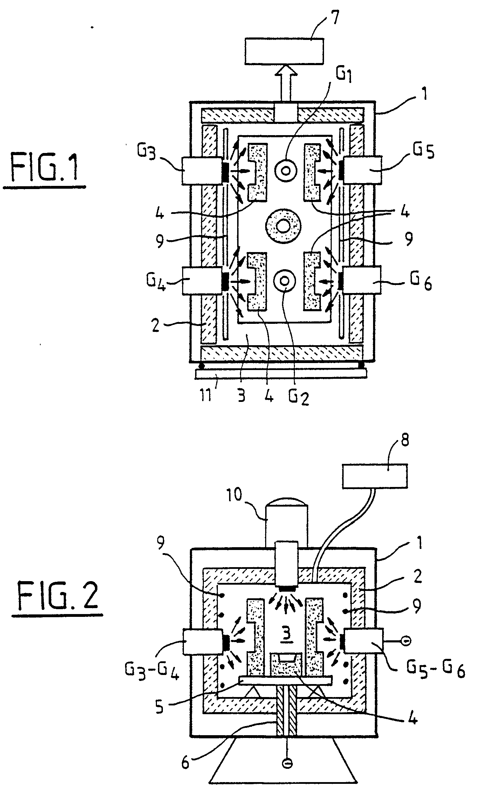

Le four représenté sur les figures 1 et 2 présente une structure classique de four de traitement thermique sous vide à bombardement ionique.

Il comprend une enceinte étanche 1, à simple ou à double parois métalliques éventuellement refroidies par circulation d'eau dans l'espace intercalaire compris entre les deux parois.

A l'intérieur de cette enceinte 1 est disposé un moufle 2 ou "casing" réalisé en un matériau thermiquement isolant qui délimite le laboratoire 3 du four.

A l'intérieur de ce laboratoire 3, les pièces à traiter 4 sont posées sur un support 5 en matériau électriquement conducteur sur lequel peut être appliquée une tension de polarisation (par exemple une tension continue pulsée de quelques centaines de volts), grâce à un passage de courant 6 qui traverse l'enceinte de façon étanche et qui est électriquement isolé de celle-ci.

Comme dans tous les fours de traitement thermique sous vide, le volume intérieur de l'enceinte 1 communique, d'une part, avec une station de pompage extérieure 7 permettant d'obtenir un vide relatif (par exemple de 8 x 10⁻³ mbar à 10⁻¹ mbar) et, d'autre part, avec une source 8 de gaz neutre ou de gaz réactif.

Le chauffage des pièces à la température de traitement, ici, entre 400°C et 1300°C, est obtenu grâce à des résistances chauffantes 9, par exemple en graphite, portées par les parois internes du moufle 2, tandis que leur refroidissement est assuré grâce à une circulation de gaz injectés dans le four en fin de traitement. La circulation de ces gaz à l'intérieur du four, éventuellement sur un échangeur thermique, est produite par une turbine 10. Avantageusement, ce circuit est conçu de manière à pouvoir effectuer une trempe à gaz surpressé.

Dans cet exemple, le four est équipé de six générateurs de vapeur G₁ à G₆, à savoir :
- deux générateurs G₁, G₂ à cible horizontale montés sur la face supérieure de l'enceinte 1 ;
- quatre générateurs à cible verticale G₃, G₄, G₅, G₆ montés sur deux parois verticales opposées de l'enceinte 1.

Bien entendu, chacun de ces générateurs traverse l'enceinte 1 ainsi que le moufle de manière à ce que la cible se trouve dans le laboratoire, au voisinage des pièces 4 à traiter.

L'accès à l'intérieur du four est assuré grâce à une porte frontale étanche 11 thermiquement isolée de manière à constituer également la porte du moufle 2.

Comme précédemment mentionné, les générateurs de vapeur G₁ à G₆, en particulier ceux dont la cible est verticale, devront être conçus de manière à créer la phase vapeur par sublimation directe du métal constituant la cible.

A cet effet, ces générateurs pourront être conçus de manière à pouvoir mettre en oeuvre un procédé d'évaporation par arcs électriques qui consiste à produire une vapeur métallique par des arcs électriques se déplaçant à la surface de la cible, et à la combiner ou non avec un gaz réactif donné, pour synthétiser un métal, un alliage ou un composé de type nitrure, carbure, oxyde, sous forme de couche mince sur un substrat.

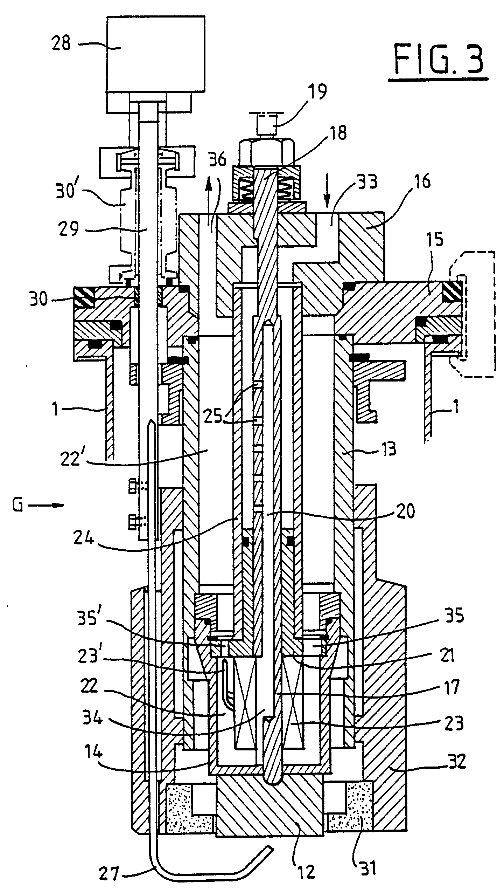

Un tel générateur G peut comprendre, comme représenté sur la figure 3 :
- une cible 12 en forme de tronçon cylindrique, réalisée en le matériau à évaporer et à déposer sur les pièces à traiter 4, (étant entendu que les cibles utilisées dans un même four peuvent être de natures différentes, de manière à réaliser des dépôts incluant plusieurs éléments, par exemple plusieurs métaux) ;
- une structure support comprenant un manchon tubulaire 13 dont une extrémité, refermée par un fond 14, porte coaxialement la cible 12, et dont l'autre extrémité est munie d'une bride 15 engagée et fixée de façon étanche et avec une isolation électrique, dans un orifice de l'enceinte 1 du four ;
- une culasse 16, en un matériau électriquement isolant qui referme le manchon tubulaire 13 au niveau de la bride 15 et qui est traversée par un barreau 17 électriquement conducteur qui s'étend coaxialement à l'intérieur du manchon 13, vient assurer un contact électrique avec la cible 12, ce barreau 17 comprenant un embout extérieur 18 dépassant de la culasse 16 et muni de moyens de raccordement 19 à un circuit électrique ; ce barreau présente, du côté de la cible 12, un canal coaxial 20 ;
- une douille épaulée 21 qui sépare le volume compris entre le manchon tubulaire 13 et le barreau 17 en deux chambres 22, 22' ;
- une bobine électromagnétique 23 montée autour du barreau 17 dans la chambre adjacente 22 à la cible 12, cette bobine 23 servant à créer un champ magnétique au voisinage de la cible 12 ;
- un tube isolant 24 qui s'étend dans la chambre 22', coaxialement au barreau 17, entre la culasse 16 et la douille 21, ce tube délimitant avec le barreau 17 un volume intercalaire qui communique avec le canal 20 grâce à des orifices de passage 25 formés dans le barreau 17 ;
- un dispositif d'initiation de la décharge d'arc qui fait intervenir une électrode excitatrice 27, en métal ou alliage réfractaire par exemple en molybdène, guidée parallèlement à l'axe du manchon tubulaire 13, à l'extérieur de celui-ci, cette électrode 27 présentant une extrémité recourbée qui vient en regard de la cible 12 ;
- un mécanisme d'actionnement de l'électrode excitatrice 27, ce mécanisme comprenant un élément moteur (vérin 28) situé à l'extérieur du four et une tige d'actionnement 29 sur laquelle vient se fixer l'électrode 27, cette tige 29 étant montée (coulissante, voire même rotative), de façon étanche dans des paliers 30 traversant la bride 15 (l'étanchéité étant assurée par des soufflets d'étanchéité 30') ;
- un écran 31 à potentiel flottant, par exemple en graphite, qui se présente sous la forme d'une couronne montée coulissante autour de la cible 12, cette couronne étant portée par un manchon tubulaire 32 de support coaxial au manchon tubulaire 13 et pouvant coulisser sur ce dernier ; et
- un circuit de fluide de refroidissement faisant intervenir un conduit d'admission connecté à un canal d'admission 33 réalisé dans la culasse 16 et débouchant dans le volume intercalaire compris entre le barreau 17 et le tube isolant 24, un fraisage axial 34 pratiqué dans le barreau 17 et faisant communiquer le canal axial 20 et la chambre 22, des orifices de passage 35 pratiqués dans la douille 21 pour établir la communication entre les chambres 22 et 22' et un conduit de reprise connecté à un canal de reprise 36 réalisé dans la culasse 16.

Le fonctionnement du générateur de vapeur précédemment décrit est alors le suivant :

On applique au barreau 17 et, par conséquent, à la cible 12, un courant continu basse tension (inférieur à 100 volts) haute intensité (10 à 400 ampères) fourni par un générateur électrique du type de ceux utilisés dans les postes à souder à arc électrique.

Grâce à l'électrode 27, on provoque une décharge d'arc électrique qui est localisée sur la surface de la cible 12 grâce à l'écran 31 qui est porté à un potentiel flottant.

Parallèlement, on alimente la bobine 23 (grâce à des conducteurs 23' passant par des orifices 35') de manière à créer un champ magnétique appliqué à la cible 12.

Ce champ magnétique permet de confiner le plasma et de contrôler le mouvement de la décharge d'arc sur la cible 12.

En fait, la cible constitue une cathode d'un générateur de plasma dans lequel l'enceinte 1 du four, voire même les résistances chauffantes 9, constituent l'anode.

Les pièces à traiter 4 sont, quant à elles, polarisées négativement au cours du dépôt au moyen d'une tension continue pulsée de quelques centaines de volts.

Grâce aux dispositions précédemment décrites, l'ensemble du générateur (en particulier la cible 12, et la bobine électromagnétique 23) est refroidi par la circulation du fluide réfrigérant. Ceci permet d'avoir une température de la surface de la cible 12 très élevée, voire voisine de la température de fusion du matériau de la cible, tout en maintenant le reste du générateur à une température relativement basse.

On obtient donc au niveau de la cible, un triple processus :
- décharge électrique luminescente anormale engendrant sur la cible 12 un plasma, et ce, en raison du potentiel cathodique et du champ électrique ;
- décharge en régime d'arc provoquée par l'électrode 27 ;
- application d'un champ magnétique au niveau de la cible 12 qui permet d'augmenter l'intensité du bombardement ionique et permet le déplacement concentrique et rapide des spots d'arc.

En raison de ces trois effets, la surface de la cible 12 subit un échauffement intense et, sous l'impact des ions du gaz ionisé et de la décharge d'arc, libère de la matière par un phénomène de sublimation.

Le transfert de la matière libérée au niveau de la cible 12, dans l'atmosphère neutre ou réactive du four, s'effectue principalement par un mécanisme de transport en phase gazeuse ionisée, l'action du champ électrique établi entre le générateur et les pièces à traiter, dépendant de la distance entre ces deux éléments et pouvant être privilégiée pour ce qui concerne les générateurs latéraux G₃ à G₆.

Sous l'effet de la différence de potentiel entre les pièces à traiter 4 et l'anode, il se crée au niveau des pièces à traiter 4, une deuxième décharge électrique luminescente anormale permettant d'améliorer, (par des phénomènes de diffusion ou d'interdiffusion à l'interface substrat/dépôt et par des phénomènes de condensation assistés par bombardement ionique) la restructuration du dépôt de matière et son adhérence.

On constate que ces phénomènes sont considérablement amplifiés dans la gamme de température prévue dans le procédé selon l'invention, en particulier entre 800°C et 1300°C.

Bien entendu, il est préférable d'effectuer sur les pièces 4 un traitement de surface préalablement et/ou postérieurement à la phase de dépôt, notamment en vue d'assurer une liaison substrat/dépôt possédant un niveau de dureté graduel, à limiter les contraintes mécaniques dans la zone interfaciale et à assurer une excellente adhérence substrat/dépôt.

A cet effet, plusieurs alternatives sont possibles :
a) Réalisation d'un traitement d'enrichissement en carbone de la surface des pièces en acier jusqu'à une teneur de l'ordre de 0,8 %. Il s'agit alors d'un traitement de cémentation assisté ou non par plasma.
b) Réalisation d'une couche superficielle surenrichie en carbone de façon à obtenir la formation de carbures fins et sphéroïdaux, ayant une teneur superficielle en carbone comprise entre 0,8 et 2 %. Il s'agit d'un traitement de supercarburation généralement appliqué aux aciers contenant des éléments d'alliage carburigène (Cr, Mo, W, V, Nb...). Ce traitement, de même que le traitement a), peuvent être suivis dans le même cycle, par un dépôt réalisé également à haute température, et un traitement de trempe martensitique au gaz surpressé, de façon à durcir la sous-couche cémentée.
c) Réalisation d'un traitement de nitruration ionique sur alliage de titane à haute température suivi d'un dépôt de nitrure de titane, par exemple.
d) Il peut être avantageux de réaliser un traitement thermique de diffusion à haute température après dépôt à chaud de manière à réaliser une interdiffusion entre les éléments du substrat et ceux du revêtement.

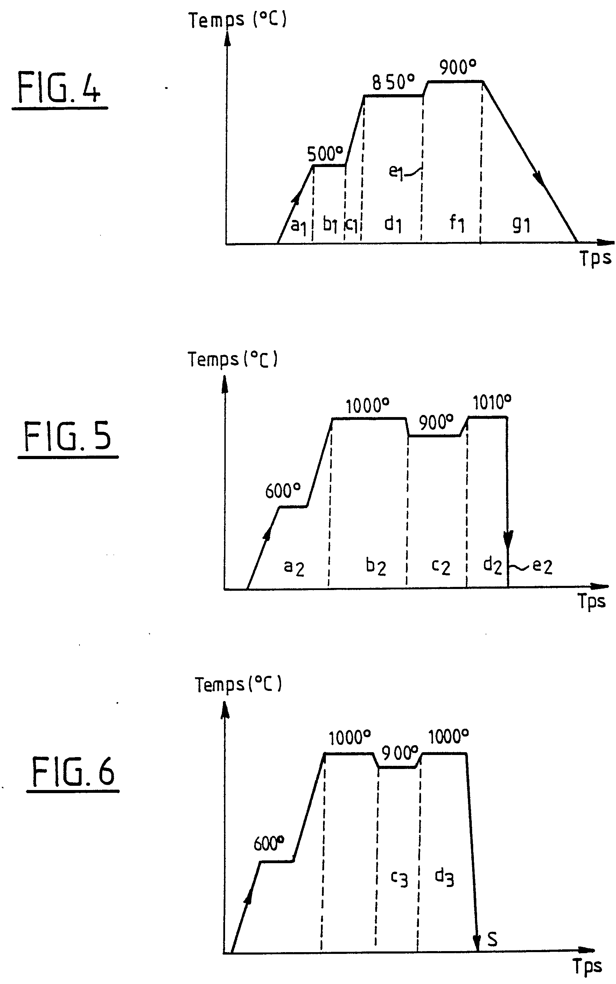

Les figures 4 à 9 illustrent des exemples de traitement réalisables conformément au procédé selon l'invention.

### Exemple 1 (figure 4)

Cet exemple concerne un cycle de traitement mixte de nitruration ionique suivi d'un dépôt de nitrure de titane à haute température comprenant les phases suivantes :
- une première phase de chauffage sous vide a₁ jusqu'à 500°C,
- un palier d'homogénéisation b₁ à 500°C,
- une seconde phase de chauffage c₁ de 500°C jusqu'à 850°C,
- une phase de nitruration ionique d₁ à 850°C,
- une phase de chauffage e₁ de 850°C à 900°C,
- une phase de dépôt de nitrure de titane f₁ à 900°C,
- une phase de refroidissement g₁.

### Exemple 2 (figure 5)

Cet exemple concerne un traitement mixte de supercarburation ionique ou basse pression suivi d'un dépôt à haute température, par exemple de nitrure de chrome, puis austénitisation et trempe martensitique au gaz surpressé. Ce traitement, qui convient aux aciers de traitement à chaud (par exemple un acier pour matrice de forge à chaud) Z 38 CDV 5, comprend les phases suivantes :
- une première phase de chauffage sous vide a₂, jusqu'à 600°C, un palier puis un nouveau chauffage jusqu'à 1000°C
- une deuxième phase de surcarburation ionique b₂ à 1000°C,
- une phase c₂ de dépôt à 900°C (par exemple de nitrure de chrome),
- une phase d'austénitisation d₂ à 1010°C,
- une phase de trempe au gaz surpressé e₂.

### Exemple 3 (figure 6)

Cet exemple concerne un traitement mixte de surcarburation ionique suivi d'un dépôt de bore à haute température, puis une phase de diffusion. Ce traitement est similaire à celui précédemment décrit à la différence que pendant le palier c₃ à 900°C, on effectue un dépôt de bore et la phase suivante d₃ qui est un palier à 1000°C, est une phase de diffusion avec formation de carbure de bore par migration du carbone vers le bore.

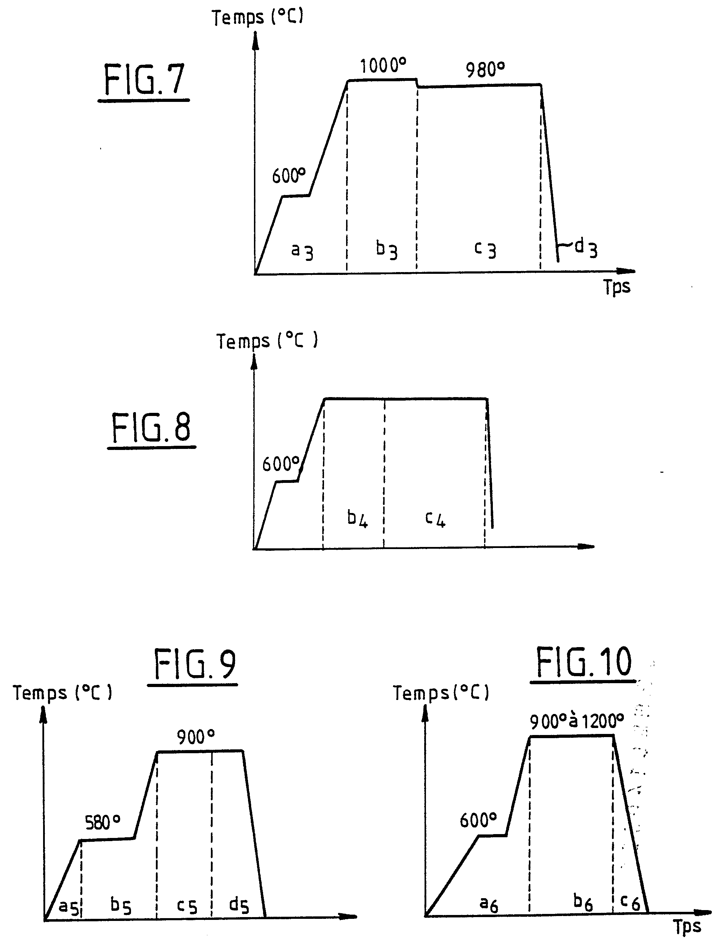

### Exemple 4 (figure 7)

Cet exemple concerne un traitement mixte de dépôt de chrome à haute température suivi d'une phase de diffusion sous vide. Il comprend :
- une phase de chauffage sous vide a₃ jusqu'à 1000°C avec un palier à 600°C,
- un palier à 1000°C b₃ avec dépôt de chrome pur,
- une phase de diffusion sous vide c₃ à 980°C,
- une phase de trempe au gaz surpressé d₃.

Ce traitement permet d'obtenir la formation d'une couche de carbures de chrome de type Cr₂₃ C₆ et Cr₇ C₃ de haute dureté (≈ 2000 HV) sur acier au carbone.

### Exemple 5 (figure 8)

Cet exemple concerne un traitement mixte de dépôt de bore similaire au traitement précédent, à la différence que la phase de dépôt de bore b₄ et la phase de diffusion sous vide c₄ s'effectuent à la température de l'ordre de 900°C.

Ce traitement permet d'obtenir la formation de borures de fer de type FeB et Fe₂B de haute dureté (2000 HV).

### Exemple 6 (figure 9)

Cet exemple concerne un traitement mixte de nitruration ionique suivi d'un dépôt de chrome diffusé. Ce traitement comprend :
- une phase a₅ de chauffage sous vide jusqu'à 580°C,
- une phase b₅ de nitruration ionique à 580°C suivie d'un chauffage jusqu'à 900°C,
- une phase c₅ de dépôt de chrome à 900°C,
- une phase d₅ de diffusion à 900°C, et
- une trempe au gaz surpressé.

Ce traitement permet d'obtenir une couche de chrome de très haute dureté.

### Exemple 7 (figure 10)

Cet exemple concerne un traitement de cémentation ou de supercarburation effectué par exemple sur un acier au carbone pour outillages portés à haute température, ce traitement étant obtenu par évaporation ou sublimation d'une cible en graphite, et pouvant ensuite comprendre une phase de diffusion et une trempe au gaz surpressé.

Tel qu'illustré sur la figure 10, ce traitement comprend :
- une phase a₆ de chauffage sous vide jusqu'à 900 à 1200°C, suivant la nature de l'acier,
- une phase b₆ d'évaporation et de sublimation avec diffusion de carbone simultané assurant une cémentation de l'acier (sans hydrocarbure d'apport gazeux),
- une trempe au gaz surpressé c₆.

Bien entendu, l'invention ne se limite pas à ces exemples, de nombreux autres dépôts pouvant être effectués.

A cet effet, les matériaux constituant la cible à évaporer peuvent indifféremment consister en :
- un métal pur tel que, par exemple, le titane, le hafnium, le chrome, le nickel, le bore, le tungstène,
- un alliage binaire (par exemple du type Ti-Al, Cr-Al, Cr-Ni, Cr-Ti, Fe-Si...),
- un alliage complexe multi-éléments (MCrAlY, NiCoCrAlYTa, Ti-Hf-Al...).

De même, durant la phase de dépôt, il peut être introduit dans le four un gaz neutre tel que de l'argon, le l'hélium, de l'hydrogène ou d'autre gaz, de façon stabiliser la décharge d'arc, à favoriser l'ionisation ou à adapter une pression de travail précise. Un gaz réactif peut être injecté en cours du dépôt afin de combiner la vapeur métallique et former un composé de type nitrure, oxyde, carbure de métaux ou une combinaison de ces gaz permettant d'élaborer des composés mixtes de type carbonitrure, oxynitrure, etc...

## Revendications

1. Procédé de traitement thermochimique de métaux par dépôt physique sous vide en phase vapeur (PVD) de matière sur un substrat métallique à traiter, procédé selon lequel on évapore la substance d'une cible au moins en partie métallique qui constitue une première électrode d'un four de traitement par un bombardement ionique éventuellement assisté par une décharge d'arc électrique, et à déposer les particules ainsi évaporées sur un substrat porté à un potentiel d'une deuxième électrode qui est différent de celui de la première électrode, de manière à engendrer une décharge luminescente sur ledit substrat, celui-ci étant porté, au cours de ce dépôt, à une température de traitement,
caractérisé en ce que ladite température de traitement est supérieure à 600°C, et est, de préférence, comprise entre 800°C et 1300°C, et en ce que ladite cible ainsi que ses organes annexes situés dans le four soient constamment refroidis par un courant de fluide de refroidissement de manière à ce que, lorsque l'on atteint la température de traitement, la matière de la cible demeure solide et que l'évaporation produite à la surface de la cible s'effectue par sublimation.

2. Procédé selon la revendication 1,
caractérisé en ce que le matériau constituant la cible consiste en un métal pur tel que du titane, du hafnium, du chrome, du nickel, du bore ou du tungstène.

3. Procédé selon la revendication 1,
caractérisé en ce que le matériau constituant la cible consiste en un alliage binaire tel que, par exemple, de Ti-Al, du Cr-Al, de Cr-Ni, du Cr-Ti ou du Fe-Si.

4. Procédé selon l'une des revendications précédentes,
caractérisé en ce qu'au cours de la phase de dépôt, on introduit dans le four un gaz neutre.

5. Procédé selon l'une des revendications 1 à 3,
caractérisé en ce qu'au cours du dépôt on introduit dans le four un gaz réactif ou une combinaison de gaz réactifs.

6. Procédé selon l'une des revendications précédentes,
caractérisé en ce qu'il comprend un traitement de surface précédant la phase de dépôt.

7. Procédé selon la revendication 6,
caractérisé en ce que le traitement de surface comprend un enrichissement en carbone de la surface du substrat.

8. Procédé selon la revendication 7,
caractérisé en ce que ledit enrichissement est obtenu par un traitement de cémentation assisté ou non par plasma.

9. Procédé selon la revendication 6,
caractérisé en ce que le traitement de surface comprend la réalisation d'une couche superficielle surenrichie en carbone.

10. Procédé selon la revendication 6,
caractérisé en ce que le traitement de surface comprend une nitruration ionique.

11. Procédé selon l'une des revendications précédentes,
caractérisé en ce qu'il comprend, après la phase de dépôt, un traitement thermique de diffusion à haute température.

12. Procédé selon l'une des revendications précédentes,
caractérisé en ce qu'il comprend une phase de trempe à gaz surpressé.

13. Four permettant la mise en oeuvre du procédé selon l'une des revendications précédentes, ce four comprenant une enceinte étanche (1) à l'intérieur de laquelle est disposé un moufle (2) réalisé en un matériau thermiquement isolant qui délimite un laboratoire dans lequel les pièces à traiter peuvent être placées sur un support (5) en matériau électriquement conducteur sur lequel peut être appliquée une tension de polarisation, le volume intérieur de l'enceinte (1) communiquant avec une station de pompage à vide (7) ainsi qu'avec un circuit de distribution (8) de gaz neutre ou de gaz réactif pouvant circuler à l'intérieur du four grâce à une turbine (10), le chauffage des pièces étant obtenu grâce à des résistances chauffantes logées à l'intérieur du moufle, ledit four étant équipé d'au moins un générateur de vapeur (Gₗ à G₆) dont la cible est disposée à l'intérieur du moufle, à proximité des pièces à traiter, caractérisé en ce que ce générateur de vapeur comprend :
- une structure support formée par un manchon tubulaire (13) dont une extrémité, refermée par un fond (14), porte la cible (12) et dont l'autre extrémité est munie d'une bride (15) engagée et fixée de façon étanche, avec isolation électrique, dans un orifice de l'enceinte du four ;
- une culasse (16) en matériau isolant qui renferme le manchon tubulaire (13) et qui est traversée par un barreau (17) électriquement conducteur qui s'étend coaxialement à l'intérieur du manchon (13), et est connecté électriquement à la cible (12), ce barreau (17) étant raccordé à un circuit électrique et comprenant un canal axial (20) ;
- un tube isolant (24) disposé coaxialement au barreau de manière à délimiter avec ledit barreau (17) un premier volume intercalaire qui s'étend entre la culasse (16) et une douille (21) et qui communique avec le canal axial (20) grâce à des perçages (25) pratiqués dans le barreau (17).
- une bobine électromagnétique (23) montée autour du barreau (17), à proximité de la cible (12) ; et
- un circuit de refroidissement comprenant un conduit d'admission (33) de fluide de refroidissement traversant la culasse (16) et communiquant avec le premier volume intercalaire, un orifice (34) réalisé dans le barreau (17) au voisinage de la cible (12), pour faire communiquer le canal axial (20) et un second volume intercalaire compris entre le manchon tubulaire (13) et le barreau (17), et un conduit de reprise (36) traversant la culasse (16) et débouchant dans le-second volume intercalaire.

14. Four selon la revendication 13,
caractérisé en ce qu'il comprend en outre une électrode mobile (27) servant à initier une décharge d'arc sur la cible (12).

15. Four selon l'une des revendications 13 à 14,
caractérisé en ce que le générateur comprend un écran (31) présentant la forme d'une couronne montée coulissante autour de la cible (12) et portée à un potentiel flottant.

## Patentansprüche

1. Verfahren zur thermochemischen Behandlung von Metallen durch physikalisches Aufbringen unter Vakuum in der Dampfphase (PVD) von Materie auf ein zu behandelndes Substrat, Verfahren nach dem man die Substanz eines mindestens teilweise metallischen Targets, das eine erste Elektrode eines Behandlungsofens bildet, durch Ionenbeschuss, eventuell unterstützt durch eine Lichtbogenentladung, verdunstet und die so verdunsteten Partikel auf ein Substrat aufbringt, das auf ein Potential einer zweiten Elektrode gebracht wurde, welches sich von dem der ersten Elektrode unterscheidet, um eine lumineszente Entladung auf besagtem Substrat zu bewirken, wobei das Substrat während dieses Aufbringens auf eine Behandlungstemperatur gebracht wird,
dadurch gekennzeichnet, dass diese Behandlungstemperatur höher ist als 600°C und vorzugsweise zwischen 800° und 1300°C liegt, und dass das Target, wie auch seine im Ofen angeordneten zugehörigen Organe, durchgehend von einem Kühlfluidstrom abgekühlt werden, sodass, wenn die Behandlungstemperatur erreicht ist, die Materie des Targets fest bleibt, und dass die an der Oberfläche des Targets erzeugte Verdunstung durch Sublimation erfolgt.

2. Verfahren nach Anspruch 1,
dadurch gekennzeichnet, dass die das Target bildende Materie aus einem reinen Metall wie Titan, Hafnium, Chrom, Nickel, Bor oder Wolfram besteht.

3. Verfahren nach Anspruch 1,
dadurch gekennzeichnet, dass die das Target bildende Materie aus einer binären Legierung wie z.b. Ti-Al, Cr-Al, Cr-Ni, Cr-Ti oder Fe-Si besteht.

4. Verfahren nach einem der vorhergehenden Ansprüche,
dadurch gekennzeichnet, dass während der Aufbringungsphase ein Neutralgas in den Ofen geleitet wird.

5. Verfahren nach einem der Ansprüche 1 bis 3,
dadurch gekennzeichnet, dass während der Aufbringung ein Reaktivgas oder eine Kombination von Reaktivgasen in den Ofen geleitet wird.

6. Verfahren nach einem der vorhergehenden Ansprüche,
dadurch gekennzeichnet, dass es vor der Aufbringungsphase eine Oberflächenbehandlung aufweist.

7. Verfahren nach Anspruch 6,
dadurch gekennzeichnet, dass die Oberflächenbehandlung in einer Anreicherung der Substratoberfläche mit Kohlenstoff besteht.

8. Verfahren nach Anspruch 7,
dadurch gekennzeichnet, dass diese Anreicherung durch eine Zementierbehandlung erhalten wird, die von Plasma unterstützt wird oder nicht.

9. Verfahren nach Anspruch 6,
dadurch gekennzeichnet, dass die Oberflächenbehandlung die Herstellung einer mit Kohlenstoff überreicherten Oberflächenschicht enthält.

10. Verfahren nach Anspruch 6,
dadurch gekennzeichnet, dass die Oberflächenbehandlung eine ionische Nitrierhärtung enthält.

11. Verfahren nach einem der vorhergephenden Ansprüche,
dadurch gekennzeichnet, dass es nach der Aufbringungsphase eine Wärmebehandlung durch Diffusion bei hoher Temperatur aufweist.

12. Verfahren nach einem der vorhergehenden Ansprüche, dadurch gekennzeichnet, dass es eine Härtungsphase bei Überdruckgas enthält.

13. Ofen zur Anwendung des Verfahrens nach einem der vorhergehenden Ansprüche, wobei dieser Ofen einen dichten Raum (1) aufweist, in dessen Inneren sich ein Muffel (2) befindet, der aus einem wärmeisolierenden Material besteht und ein Labor eingrenzt, in dem die zu behandelnden Stücke auf einen Träger (5) aus elektrisch leitendem Material angeordnet werden können, an den eine Polarisationsspannung angelegt werden kann, wobei das innere Volumen des Raums (1) mit einer Vakuumpumpanlage (7) und mit einem Verteilkreis (8) für Neutralgas oder Reaktivgas verbunden ist, das aufgrund einer Turbine (10) im Inneren des Ofens zirkulieren kann, wobei das Aufheizen der Stücke durch Heizwiderstände geschieht, die im Inneren des Muffels angeordnet sind, wobei dieser Ofen mit mindestens einem Dampferzeuger ( G₁ bis G₆) ausgestattet ist, dessen Target im Inneren des Muffels in der Nähe der zu behandelnden Stücke angeordnet ist,
dadurch gekennzeichnet, dass dieser Dampferzeuger aufweist :
- eine Trägerstruktur bestehend aus einer rohrförmigen Muffe (13), deren eines Ende, das von einem Boden (14) verschlossen wird, das Target (12) trägt und dessen anderes Ende mit einem Flansch (15) versehen ist, der in eine Öffnung des Ofenraums elektrisch isoliert und dicht eingesetzt und befestigt ist ;
- ein Joch (16) aus isolierenden Material, das die rohrförmige Muffe (13) umschliesst und das von einem elektrisch leitenden Stab (17) durchquert wird, der sich koaxial im Inneren der Muffe (13) erstreckt und elektrisch mit dem Target (12) verbunden ist, wobei dieser Stab mit einem Stromkreis verbunden ist und einen axialen Kanal (20) aufweist ;
- ein isolierendes Rohr (24), das koaxial zum Stab (17) so angeordnet ist, dass es mit besagtem Stab ein erstes Zwischenvolumen bildet, das sich zwischen dem Joch (16) und einer Hülse (21) erstreckt und mit dem axialen Kanal (20) durch im Stab (17) angebrachte Bohrungen (25) in Verbindung steht ;
- eine elektromagnetische Spule (23), die in der Nähe des Targets (12) um den Stab herum angeordnet ist ; und
- einen Kühlkreis, der eine Einlassleitung (33) für Kühlfluid aufweist, die das Joch (16) durchquert und mit dem axialen Kanal (20) verbunden ist, eine Öffnung (34) in dem Stab (17) in der Nähe des Targets (12), um den aixalen Kanal mit einem zweiten Zwischenvolumen zu verbinden, das zwischen der rohrförmigen Muffe (13) und dem Stab (17) liegt, und eine Auffangleitung (36), die das Joch (16) durchquert und in das zweite Zwischenvolumen mündet.

14. Ofen nach Anspruch 13,
dadurch gekennzeichnet, dass er weiter eine bewegliche Elektrode (27) aufweist, die eine Bogenentladung auf das Target (12) auslöst.

15. Ofen nach einem der Ansprüche 13 bis 14,
dadurch gekennzeichnet, dass der Dampferzeuger einen Schirm (31) in Form einer Krone aufweist, die gleitend um das Target (12) angeordnet ist und auf ein schwimmendes Potential gebracht wird.

## Claims

1. A thermochemical treatment method of metals by physical vapor deposition (PVD) of material on a metal substrate to be treated, in which the substance of an at least partially metallic target which constitutes a first electrode of a treatment furnace is evaporated by ion bombardment optionally assisted by an electrical arc discharge, and the particles evaporated in this manner are deposited onto a substrate at the potential of a second electrode which is different from that of the first electrode, so as to generate a luminescent discharge on said substrate which is heated during this deposition to a treatment temperature,
characterized in that said treatment temperature exceeds 600°C and is preferably between 800°C and 1 300°C, and in that said target and its ancillary members in the furnace are continuously cooled by a flow of cooling fluid so that when the treatment temperature is reached, the material of the target remains solid and the evaporation occurring at the surface of the target is effected by sublimation.

2. Method according to claim 1,
characterized in that the material of the target is a pure metal such as titanium, hafnium, chromium, nickel, boron or tungsten.

3. Method according to claim 1,
characterized in that the material of the target is a binary alloy such as Ti-Al, Cr-Al, Cr-Ni, Cr-Ti or Fe-Si.

4. Method according to one of the preceding claims,
characterized in that a neutral gas is introduced into the furnace during the deposition phase.

5. Method according to one of claims 1 to 3,
characterized in that a reactive gas or a combination of reactive gases is introduced into the furnace during the deposition phase.

6. Method according to one of the preceding claims,
characterized in that it comprises a surface treatment phase preceding the deposition phase.

7. Method according to claim 6,
characterized in that the surface treatment includes carbon enrichment of the substrate surface.

8. Method according to claim 7,
characterized in that said enrichment is obtained by a carburizing treatment with optional plasma assistance.

9. Method according to claim 6,
characterized in that the surface treatment produces a surface layer over-enriched with carbon.

10. Method according to claim 6,
characterized in that the surface treatment comprises ion nitriding.

11. Method according to one of the preceding claims,
characterized in that it comprises high-temperature diffusion heat treatment after the deposition phase.

12. Method according to one of the preceding claims, characterized in that it comprises a gas quench phase.

13. Furnace for implementing the method according to one of the preceding claims, said furnace comprising a sealed enclosure (1) containing a thermally insulative material casing (2) which delimits a laboratory in which the parts to be treated may be placed on an electrically conductive material support (5) to which a bias voltage may be applied, the interior volume of the enclosure (1) communicating with a vacuum pumping station (7) and with a circuit (8) for distribution of a neutral gas or a reactive gas that may be circulated inside the furnace by a turbine (10), the parts being heated by electrical heating elements inside the casing, said furnace being fitted with at least one vapor generator (G₁ to G₆) whose target is disposed inside the casing near the parts to be treated,
characterized in that said vapor generator comprises :
- a support structure in the form of a tubular sleeve (13) one end of which is closed by a bottom (14) and carries the target (12) and the other end of which is provided with a flange (15) inserted, fixed and sealed into an orifice in the enclosure of the furnace from which it is electrically insulated ;
- an insulative material block (16) which closes off the tubular sleeve (13) and through which passes an electrically conductive bar (17) extending coaxially inside the sleeve (13) and connected electrically to the target (12), said bar (17) being connected to an electrical circuit and comprising an axial passage (20) ;
- an insulating tube (24) disposed coaxially with the bar so as to delimit with said bar (17) a first intermediate volume extending between the block (16) and a bush (21), and in communication with the axial passage (20) by means of borings (25) formed in the bar (17) ;
- an electromagnet coil (23) around said bar (17) near said target (12) ; and
- a cooling circuit comprising a cooling fluid inlet pipe (33) passing through said block (16) and communicating with said first intermediate volume, an orifice (34) formed in said bar (17) near said target (12) to provide communication for said axial passage (20) and a second intermediate volume between said tubular sleeve (13) and the bar (17), and a return pipe (36) passing through said block (16) and discharging into said second intermediate volume.

14. Furnace according to claim 13,
characterized in that it further comprises a mobile electrode (27) adapted to initiate an arc discharge on said target (12).

15. Furnace according to one of claims 13 and 14,
characterized in that said generator comprises a screen (31) in the form of a ring around and sliding on said target (12) and at a floating potential.
